# EUROPEAN PATENT SPECIFICATION

(11) **EP 0 548 407 B1**
(45) Date of publication and mention of the grant of the patent: **20.03.1996**
(21) Application number: 91122326.1
(22) Date of filing: 27.12.1991
(51) Int. Cl.: C23C 16/14, C23C 16/52, H01L 21/285, C23C 16/08

(54) **Tungsten chemical vapor deposition method**
CVD-Verfahren zur Herstellung von Wolfram
Méthode de dépôt chimique en phase vapeur de tungstene

(43) Date of publication of application: 30.06.1993
(73) Proprietor: SMALL POWER COMMUNICATION SYSTEMS RESEARCH LABORATORIES CO., LTD., Sendai-shi, Miyagi-ken (JP)
(72) Inventor: Hirano, Kiichi, Small Power Communication Systems, Aoba-ku, Sendai-shi, Miyagi-ken (JP); Takeda, Nobuo, Small Power Communication Systems, Aoba-ku, Sendai-shi, Miyagi-ken (JP)
(74) Representative: Sajda, Wolf E., Dipl.-Phys.

(56) References cited:
- EP-A- 0 252 667
- US-A- 4 823 291
- A. NISHIYAMA ET AL '1988 SYMPOSIUM ON VLSI TECHNOLOGY' 10 May 1988 , THE IEEE ELECTRON DEVICES SOCIETY , SAN DIEGO, USA
- SOLID STATE TECHNOLOGY vol. 28, no. 12, 1 December 1985, NEW YORK, USA pages 51-59; E.K.BROADBENT ET AL.: "SELECTIVE TUNGSTEN PROCESSING BY LOW PRESSURE CVD"
- JOURNAL OF THE ELECTROCHEMICAL SOCIETY vol. 138, no. 3, 1 March 1991, MANCHESTER, NH, USA pages 783 - 788; J. HOLLEMAN ET AL.: 'A REFLECTOMETRIC STUDY OF THE REACTION BETWEEN SI AND WF6 DURING W-LPCVD ON SI AND OF THE RENUCLEATION DURING THE H2 REDUCTION OF WF6'

## Description

The present invention relates to a tungsten Chemical Vapor Deposition method.

In the tungsten Chemical Vapor Deposition (CVD) method, the reduction of WF₆ using hydrogen, silicon and silane is generally used. The H₂ reduction of WF₆ permits forming a tungsten film of a satisfactory quality with a sufficiently high growth rate. However, a large amount of by-product, hydrogen fluoride, is produced in the reaction. As a result, a silicon oxide film tends to be etched, making the H₂ reduction of WF₆ unsuitable for the fabrication of transistor. In addition, the surface-bonding strength between the tungsten film and the silicon substrate tends to be insufficient depending on the CVD conditions.

The Si reduction of WF₆ permits improving the surface-bonding strength between the tungsten film and the substrate, compared with the H₂ reduction of WF₆. However, the growth rate of the tungsten film is low in the case of the Si reduction of WF₆. Also, the maximum thickness of the tungsten film formed is determined by the self-limiting nature of the reaction. It follows that it is difficult to obtain a tungsten film of a desired thickness. What should also be noted is that, in the Si reduction of WF₆ a tungsten film is grown while consuming Si. In other words, the surface region of the silicon substrate tends to be encroached. It follows that it is not desirable to employ the Si reduction of WF₆ in the case of a shallow junction or a thin device region. Under the circumstances, any of the H₂ reduction of WF₆ and the Si reduction of WF₆ is not practically employed in general.

The SiH₄ reduction of WF₆ is widely employed nowadays. However, the SiH₄ reduction of WF₆ is also defective in that it is difficult to obtain a sufficiently enough surface-bonding strength between the tungsten film formed and the substrate depending on the surface conditions. To overcome the difficulty, a pretreatment is applied under the same reaction chamber, using, for example, SF₆ so as to slightly etch the surface region of the silicon substrate, before the deposition.

In another case, it is possible to form W silicide at the interface region between a silicon substrate and a tungsten film. However, it is difficult to find good conditions of silicide formation. In addition, the reproducibility in, for example, the thickness of the film is unsatisfactory.

An object of the present invention is to provide a tungsten CVD method which permits growing a tungsten film of a high quality and enough surface-bonding strength without bringing about defects within the substrate.

In the method of the present invention, a thin film is selectively grown on the surface of a silicon substrate by the reduction of WF₆ using Si, followed by selectively growing a thin film by the reduction of WF₆ using SiH₄ as disclosed in claim 1. Preferred embodiments of the invention are disclosed in claims 2 to 4. During the growth of these films, the conditions of the substrate surface are monitored by a pyrometer. Also, the opportunity to change from the Si reduction to the SiH₄ reduction of WF₆ is determined by the intensity of the infrared ray radiation. In short, the present invention employs a two-step growth utilizing the Si reduction and the SiH₄ reduction of WF₆, in which the surface condition of the thin films is monitored so as to form a satisfactory tungsten film.

This invention can be more fully understood from the following detailed description when taken in conjunction with the accompanying drawings, in which:
Figs. 1A and 1B explain how to form a tungsten film by the tungsten CVD method according to one embodiment of the present invention;
Fig. 2 schematically shows the construction of an apparatus for forming the thin tungsten film shown in Fig. 1; and
Fig. 3 exemplifies data of a thin film growth by the tungsten CVD method of the present invention.

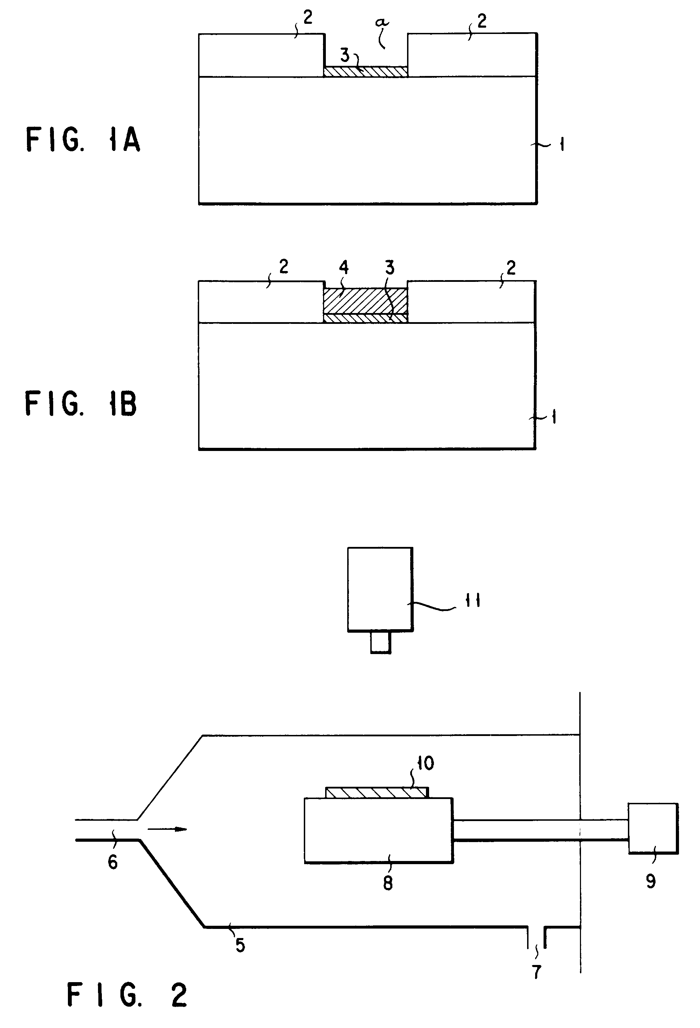

Figs. 1A and 1B collectively show a tungsten CVD method according to one embodiment of the present invention. In this embodiment, a tungsten layer is selectively grown in an opening a made in a silicon dioxide film 2 grown on a silicon substrate 1.

In a first step shown in Fig. 1A, the silicon dioxide film 2 is formed on the silicon substrate 1, followed by selectively etching the silicon oxide film 2 by techniques of, for example, photo-lithography so as to form the opening a. Then, a tungsten film 3 is grown within the opening a in a thickness of about 10 nm by a silicon reduction of WF₆ using Si is supplied from the substrate 1. The maximum thickness of the tungsten film 3 formed within the opening a is limited by the growing temperature. In general, the growing temperature is set at 350 to 450°C. In this case, the maximum thickness noted above is about 20 nm.

The growth rate is affected by the surface condition of the silicon substrate 1. Thus, in order to ensure a high reproducibility, the surface of the silicon substrate is observed so as to confirm the growth of the tungsten film 3.

In a second step shown in Fig. 1B, a tungsten film 4 is formed on the tungsten film 3 formed in the first step by the reduction of WF₆ using SiH₄. In this case, SiH₄ is added to WF₆. The tungsten film 4 can be formed in a desired thickness. It is possible to use H₂ as a carrier gas in the second step. It should be noted that the tungsten film 3 formed in the first step has enough surface-bonding strength to the silicon substrate 1. On the other hand, the thickness and the sheet resistance of the tungsten film as a whole can be controlled as desired by the formation of the tungsten film 4 in the second step.

The apparatus for working the tungsten CVD method of the present invention is constructed as shown in, for example, Fig. 2. As shown in the drawing, the apparatus comprises a reaction chamber 5. A quartz glass tube or a stainless steel chamber provided with an inlet port can be used as the reaction chamber 5. The reaction chamber 5 is provided with a gas inlet port 6 for introducing the reactant gases into the chamber 5 and with an exhaust port 7. A heater 8 utilizing an electric heater or lamp heater is disposed within the reaction chamber 5 to avoid the deposition inside the chamber. A sample 10, e.g., silicon substrate, is disposed on the heater 8. Under this condition, reactant gases such as WF₆ and SiH₄ are introduced into the reaction chamber 5 through the gas inlet port 6 so as to carry out a tungsten deposition on the sample 10. It should be noted that a pyrometer 11 is provided above the reaction chamber 5 so as to observe the surface condition of the sample 10.

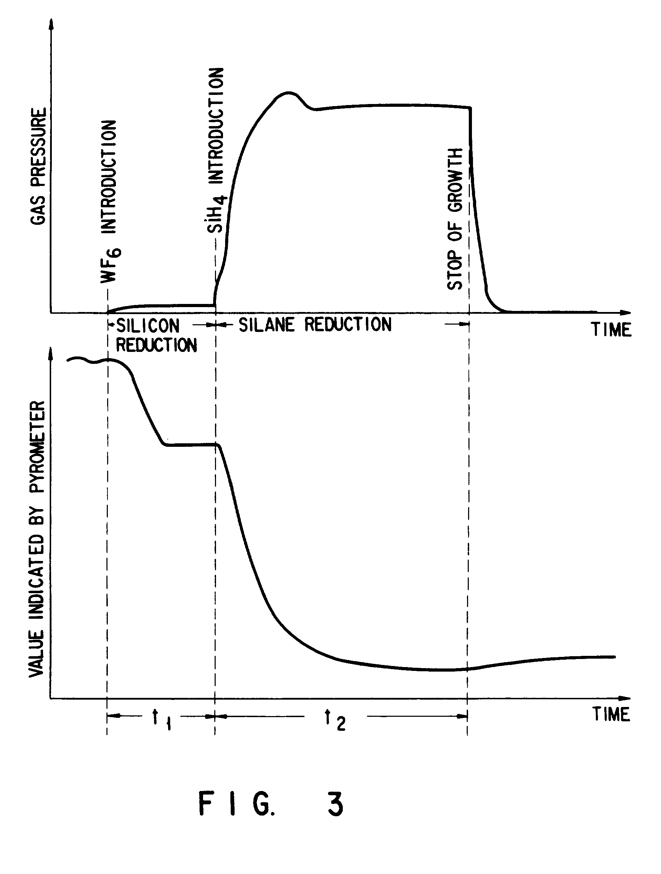

Fig. 3 shows a relation of time versus the indication of the pyrometer 11 and the gas pressure within the reaction chamber 5 in the case of forming a tungsten thin film by the method of the present invention. It should be noted that the indication of the pyrometer 11 is the intensity of the infrared light having a wavelength of 2 to 5 µm. Because of the emissivity of infrared light from tungsten is lower than that of Si, with the result that the tungsten films 3 and 4 are grown on the surface of the silicon substrate 1 with decrease in the value indicated by the pyrometer 11, as shown in the graph of Fig. 3.

To be more specific, the growth temperature is determined by the heater 9 at the beginning of the CVD operation at a predetermined value for carrying out the growth of a tungsten film by the Si reduction of WF₆ in the first step. If a tungsten source of WF₆ is introduced into the reaction chamber, the gas pressure within the reaction chamber 5 is slightly increased. After a short time from the increase in the gas pressure, we call "Initial delay time" the value indicated by the pyrometer 11 begins to be decreased, denoting the growth of the tungsten film 3. Fig. 3 shows that the characteristic curves tend to be gradually saturated, indicating that the growth rate of the tungsten film 3 is decreased.

Time t1 after introduction of WF₆, SiH₄ is introduced through the gas inlet port 6 into the reaction chamber 5 so as to achieve growth of the tungsten film 4 by the SiH₄ reduction of WF₆ in the second step. As a result, the gas pressure within the reaction chamber 5 is rapidly increased, and the value indicated by the pyrometer 11 is rapidly decreased. This indicates the growth of the tungsten film 4. The deposition can be stopped time t2 after introduction of SiH₄ into the reaction chamber 5.

However, the initial delay time in the initiation of the first step is affected by the surface condition of the silicon substrate 1, it should be noted that it is not desirable to set unduly long growth time because silicon atoms in the surface region of substrate 1 are consumed. In order to overcome the difficulty, the pyrometer 11 used in the present invention is effective. Specifically, when the pyrometer 11 indicates a first saturation, it is determined in the present invention that the tungsten film 3 has grown to have a thickness large enough to ensure a sufficient surface-bonding strength with the silicon substrate. In other words, it is the chance to introduce SiH₄ into the reaction chamber 5 so as to change the CVD mechanism the SiH₄ reduction of WF₆.

As described above, the tungsten film 3 having enough thickness can be obtained without fail regardless of various initial delay time of the growth. It follows that, even if the tungsten film 4 is further grown in the second step, obtained tungsten film obtained has a high reproducibility. The particular method of the present invention makes it possible to obtain a tungsten film of a desired thickness having a high surface-bonding strength with the substrate and a low resistivity of 6.4 µΩ·cm by a selective deposition technique.

As described above in detail, the tungsten CVD method of the present invention makes it possible to obtain a thin tungsten film having a high surface-bonding strength with the substrate and a low resistivity. Since the tungsten film can be used for filling a contact hole or as a wiring, the technique of the present invention is of a high industrial value.

## Claims

1. A tungsten chemical vapor deposition method comprising the steps of:
a first step of selectively growing a first thin tungsten film (3) of a predetermined thickness in a desired region (a) on the surface of a silicon substrate (1), placed in an atmosphere of a predetermined temperature, by reducing a WF₆ gas introduced into said atmosphere with Si; and
a second step of selectively growing a second tungsten thin film (4) of a desired thickness on said first tungsten thin film (3) by reducing said WF₆ with a second gas;
characterized in that
the second gas for reducing WF₆ is a SiH₄ gas, and the method further comprises the steps of:
monitoring the intensity of infrared radiation emitted from the growing tungsten film surface in the first step,
determining a saturation state corresponding to the predetermined thickness of said first tungsten film (3) based on the time behaviour of the intensity of infrared radiation, and
introducing the SiH₄ gas into said atmosphere to carry out said second step when said saturation state has been reached.

2. The tungsten chemical vapor deposition method of claim 1, further comprising the step of forming a mask on the silicon substrate prior to said first step to thereby define said desired region (a).

3. The tungsten chemical vapor deposition method of claim 1 or 2, wherein a pyrometer is used for monitoring said infrared intensity, the magnitude of intensity being an indication of growth thickness of said first tungsten thin film.

4. The tungsten chemical vapor deposition method of one of the claims 1, 2 or 3, wherein the timing for switching from Si reduction to SiH₄ reduction of WF₆ gas is defined in the determining step when the intensity of infrared radiation reaches a predetermined value indicative of the predetermined thickness of the first tungsten film (3).

## Patentansprüche

1. Verfahren zum chemischen Aufdampfen von Wolfram, das die folgenden Schritte aufweist:
einen ersten Schritt des selektiven Aufwachsens einer ersten dünnen Wolframschicht (3) mit vorbestimmter Dicke in einem gewünschten Bereich (a) auf der Oberfläche eines Silicium-Substrates (1), das in einer Atmosphäre bei vorbestimmter Temperatur gehalten wird, durch Reduktion von WF₆-Gas, das in die Atmosphäre eingeleitet wird, mit Si; und
einen zweiten Schritt des selektiven Aufwachsens einer zweiten Wolfram-Dünnschicht (4) mit gewünschter Dicke auf der ersten Wolfram-Dünnschicht (3) durch Reduktion des WF₆ mit einem zweiten Gas;
dadurch gekennzeichnet,
daß das zweite Gas zur Reduktion von WF₆ ein SiH₄-Gas ist und daß das Verfahren außerdem die folgenden Schritte aufweist:
Überwachen der Intensität der Infrarotstrahlung, die von der Oberfläche der aufwachsenden Wolframschicht in dem ersten Schritt emittiert wird,
Bestimmen eines Sättigungszustandes entsprechend der vorbestimmten Dicke der ersten Wolframschicht (3) auf der Basis des zeitlichen Verhaltens der Intensität der Infrarotstrahlung, und
Einleiten des SiH₄-Gases in die Atmosphäre, um den zweiten Schritt durchzuführen, wenn der Sättigungszustand erreicht worden ist.

2. Verfahren zum chemischen Aufdampfen von Wolfram nach Anspruch 1,
das weiter den Schritt der Bildung einer Maske auf dem Silicium-Substrat vor dem ersten Schritt aufweist, um den gewünschten Bereich (a) festzulegen.

3. Verfahren zum chemischen Aufdampfen von Wolfram nach Anspruch 1 oder 2,
bei dem ein Pyrometer zur Überwachung der Infrarotintensität verwendet wird, wobei der Wert der Intensität eine Anzeige für die aufgewachsene Dicke der ersten Wolfram-Dünnschicht ist.

4. Verfahren zum chemischen Aufdampfen von Wolfram nach einem der Ansprüche 1, 2 oder 3,
bei dem die zeitliche Steuerung des Wechsels von der Si-Reduktion zur SiH₄-Reduktion des WF₆-Gases in dem Bestimmungsschritt definiert wird, wenn die Intensität der Infrarotstrahlung einen vorbestimmten Wert erreicht, der die vorbestimmte Dicke der ersten Wolframschicht (3) anzeigt.

## Revendications

1. Procédé de déposition chimique de tungstène en phase vapeur, comprenant les étapes suivantes:
- une première étape de sélectivement faire croître sélectivement un premier film mince de tungstène (3) d'une épaisseur prédéterminée dans une région désirée (a) sur la surface d'un substrat en silicium (1) placé dans une atmosphère d'une température prédéterminée, en réduisant avec du Si un gaz WF₆ introduit dans ladite atmosphère ; et
- une seconde étape de sélectivement faire croître sélectivement un second film mince de tungstène (4) d'une épaisseur prédéterminée sur ledit film mince de tungstène (3) en réduisant ledit gaz WF₆ avec un second gaz;
caractérisé en ce que:
- le second gaz pour réduire le WF₆ est du gaz SiH₄, et le procédé comprend en outre les étapes de:
- surveiller l'intensité du rayonnement infrarouge émis depuis la surface du film de tungstène en croissance dans la première étape,
- déterminer un état de saturation correspondant à l'épaisseur prédéterminée dudit premier film de tungstène (3) en se basant sur l'évolution dans le temps de l'intensité du rayonnement infrarouge, et
- introduire le gaz SiH₄ dans ladite atmosphère pour procéder à ladite seconde étape lorsqu'on a atteint ledit état de saturation.

2. Procédé de déposition chimique de tungstène en phase vapeur, selon la revendication 1,
comprenant en outre l'étape de former un masque sur le substrat de silicium avant ladite première étape, pour définir ainsi ladite région désirée (a).

3. Procédé de déposition chimique de tungstène en phase vapeur, selon l'une ou l'autre des revendications 1 et 2,
dans lequel on utilise un pyromètre pour surveiller ladite intensité infrarouge, l'amplitude de l'intensité étant une indication de l'épaisseur de croissance dudit premier film mince de tungstène.

4. Procédé de déposition chimique de tungstène en phase vapeur, selon l'une quelconque des revendications 1, 2 et 3,
dans lequel la temporisation pour le passage de la réduction du gaz WF₆ au Si à la réduction au SiH₄ est définie dans l'étape de détermination lorsque l'intensité du rayonnement infrarouge atteint une valeur prédéterminée indiquant l'épaisseur prédéterminée du premier film de tungstène (3).
